# EUROPÄISCHE PATENTSCHRIFT

(11) **EP 1 002 452 B1**
(45) Veröffentlichungstag und Bekanntmachung des Hinweises auf die Patenterteilung: **23.10.2002**
(21) Anmeldenummer: 98945031.7
(22) Anmeldetag: 23.07.1998
(51) Int. Cl.: H05K 13/04

(54) **KONTAKTANORDNUNG ZUR VERBINDUNG ZWEIER SUBSTRATE SOWIE VERFAHREN ZUR HERSTELLUNG EINER DERARTIGEN KONTAKTANORDNUNG**
CONTACT ARRANGEMENT LINKING TWO SUBSTRATES AND METHOD FOR THE PRODUCTION OF SAID CONTACT ARRANGEMENT
AGENCEMENT DE CONTACTS SERVANT A RELIER DEUX SUBSTRATS ET PROCEDE POUR PRODUIRE LEDIT AGENCEMENT

(30) Priorität: 08.08.1997 DE 19734442; 20.05.1998 DE 19822559
(43) Veröffentlichungstag der Anmeldung: 24.05.2000
(73) Patentinhaber: Pac Tech - Packaging Technologies GmbH, 14641 Nauen (DE); Smart Pac GmbH Technology Services, 14641 Nauen (DE)
(72) Erfinder: SCHREDL, Jürgen, D-13347 Berlin (DE); OPPERT, Thomas, D-13595 Berlin (DE)
(74) Vertreter: Tappe, Hartmut
(86) Internationale Anmeldenummer: DE9802067
(87) Internationale Veröffentlichungsnummer: WO99008498

(56) Entgegenhaltungen:
- DE-A- 4 109 363
- DE-A- 4 138 779
- US-A- 4 569 305
- US-A- 5 611 884

## Beschreibung

Die vorliegende Erfindung betrifft eine Kontaktanordnung zur Verbindung zweier Substrate nach dem Oberbegriff des Anspruchs 1 und ein Verfahren zur Herstellung einer Kontaktanordnung gemäß Anspruch 2.

Bei der Kontaktierung von Substratanordnungen gemäß der sogenannten "Flip-Chip-Technologie", bei der in der Regel ein Chip oder auch ein Chipmodul mit seinen Anschlußflächen und dazwischen liegender Anordnung von Kontaktmetallisierungen auf Anschlußflächen einer Kontaktoberfläche einer Baugruppenplatine oder dergleichen kontaktiert wird, sind bezogen auf die Oberfläche des Chips bzw. die Oberfläche des Chipmoduls extrem hohe Kontaktdichten möglich. Dabei wird die Höhe der Kontaktdichte wesentlich mitbestimmt durch den Mindestabstand, der zwischen den einzelnen Kontaktanordnungen aufrechtzuerhalten ist, um die Entstehung von Kurzschlüssen zu verhindern. Insbesondere in den Fällen, in denen nur zwischen einem Teil der einander gegenüber liegenden Anschlußflächen die Ausbildung von Kontaktanordnungen erfolgen soll, also eine selektive Kontaktierung vorzunehmen ist, erweist es sich darüber hinaus als wesentlich, nicht nur in der Kontaktebene einen notwendigen Mindestabstand zur Vermeidung von Kurzschlüssen einzuhalten, sondern darüber hinaus auch zwischen den einander gegenüberliegenden Kontaktoberflächen der Substrate. Dies ist beispielsweise dann der Fall, wenn ein auf seiner Kontaktoberfläche mit zusätzlichen Testanschlüssen versehener Chip auf einem weiteren Substrat kontaktiert werden soll, ohne daß dabei die Testanschlüsse mit in die Kontaktierung einbezogen werden.

Zur Ausbildung von Kontaktanordnungen, die neben einer elektrisch leitfähigen Verbindung zwischen den Anschlußflächen der beiden Substrate auch die Ausbildung eines Abstands zwischen den Substratoberflächen ermöglichen, ist es bekannt, auf den Anschlußflächen des einen Substrats erhöhte Kontaktmetallisierungen, sogenannte "Bumps", auszubilden, die zur Herstellung des elektrischen Kontakts mit gleichzeitiger Ausbildung mechanischer Haltekräfte zur Sicherung des Kontakts aufgeschmolzen werden. Durch das Aufschmelzen kommt es zu einer Umverteilung des Materialvolumens der erhöhten Kontaktmetallisierungen, mit der Folge, daß sich die Höhe der Kontaktmetallisierungen und somit der durch die Höhe der Kontaktmetallisierungen definierte Abstand zwischen den Substratoberflächen verringert. Gleichzeitig kann es aufgrund der Volumenumverteilung der Kontaktmetallisierungen infolge des Aufschmelzens zu einer Verringerung des Abstandes zwischen den einzelnen Kontaktmetallisierungen kommen.

Aus der DE-A-41 09 363 ist eine Kontaktanordnung bekannt, die zur Verbindung zweier Substrate dient und eine Abstandsmetallisierung aufweist, die mit einer Anschlußfläche des ersten Subtrats verbunden ist. Zur Verbindung der Abstandsmetallisierung mit der Anschlußfläche des zweiten Substrats dient eine elektrisch leitfähige Klebermasse. Die unmittelbare Kontaktierung der Abstandsmetallisierung auf der Anschlußfläche stellt besondere Anforderungen an die Materialzusammensetzung der Abstandsmetallisierung.

Die US-A-5,611,884 zeigt ebenfalls eine Kontaktanordnung, bei der eine Abstandsmetallisierung zwischen einander zugeordneten Anschlußflächen zweier Substrate vorgesehen ist.

Aus R.J. Klein Wassink, "SOLDERING IN ELECTRONICS", Electrochemical Publications Ltd. 1989, Ayr, Scotland, ist es bekannt, Anschlußflächen aus bestimmten Materialien mit einem Überzug aus Gold und Nickel zu versehen, um die Benetzbarkeit der Anschlussfläche für übliche Zinn-Bleilotmaterialien zu verbessern.

Der vorliegenden Erfindung liegt die Aufgabe zugrunde, eine Kontaktanordnung unter Verwendung von Abstandsmetallisierungen vorzuschlagen, die mit geringerem Aufwand herstellbar ist.

Diese Aufgabe wird durch eine Kontaktanordnung mit den Merkmalen des Anspruchs 1 gelöst.

Bei der erfindungsgemäßen Kontaktanordnung ist zwischen der Anschlußfläche des ersten Substrats und der Abstandsmetallisierung eine Zwischenmetalllisierung aus einer Nickel und Gold enthaltenden Legierung vorgesehen, so daß es möglich ist, zur Ausbildung der Abstandsmetallisierung auch solche Materialien zu wählen, die nicht unmittelbar mit der Anschlußfläche des ersten Substrats kontaktierbar sind.

Dabei ist die Verbindung zwischen der Anschlussfläche des ersten Substrats und der Kontaktfläche des zweiten Substrats durch ein partielles Aufschmelzen der Abstandsmetallisierung hergestellt.

Die erfindungsgemäße Kontaktanordnung ermöglicht es, das für die Ausbildung der Abstandsmetallisierung verwendete Materialvolumen in seiner Menge und/oder Form so anzuordnen, wie es zur Erzielung der reinen Abstandsfunktion geeignet erscheint, ohne von einem nachfolgenden vollständigen Aufschmelzvorgang Beeinflusst zu werden. Bei Ausbildung der Abstandsmetallisierung aus einem Lotmaterial kann man neben der Abstandsfunktion noch in vorteilhafter Weise Nutzen aus dem plastischen Deformationsverhalten des Lotmaterials zum Abbau von in der Regel thermisch bedingten Spannungen zwischen den Substraten ziehen.

Zur Ausbildung der Abstandsmetalllisierung kann daher ein konventionelles Lotmaterial, wie beispielsweise eine Blei/Zinn-Legierung, verwendet werden, bei dessen unmittelbarer Kontaktierung auf eine Aluminiumanschlußfläche des ersten Substrats nur unzureichende mechanische Haltekräfte die Folge wären.

Das erfindungsgemäße Verfahren ermöglicht die Ausbildung einer alternativen Kontaktanordnung und weist gemäß Anspruch 2 die folgenden Verfahrensschritte auf:
- Aufbringung von Lotmaterial auf Anschlußflächen eines ersten Substrats zur Ausbildung von Abstandsmetallisierungen und
- Kontaktierung des ersten Substrats mit einem zweiten Substrat, wobei die Kontaktierung zwischen den Anschlußflächen des ersten Substrats
- und einer Kontaktoberfläche des zweiten Substrats mittels eines partiellen Aufschmelzens der Abstandsmetallisierungen erfolgt.

Vorzugsweise wird das partielle Aufschmelzen der Abstandsmetallisierungen mit Laserenergie durchgeführt, um eine möglichst diskrete Einbringung der Energie zu ermöglichen, die den wesentlichen, die Abstandsfunktion erfüllenden Teil der Abstandsmetallisierungen in seinem erstarrten Zustand beläßt.

Nachfolgend wird eine bevorzugte Ausführungsform der Kontaktanordnung zur Herstellung einer Substratanordnung anhand einer beispielhaften Verfahrensvariante zur Herstellung der Kontaktanordnung unter Bezugnahme auf die Zeichnungen näher erläutert. Es zeigen:
- **Fig. 1**: eine Kontaktanordnung zwischen einem Chip und einem Spulensubstrat zur Ausbildung eines Transponders;
**Fig. 2** eine Substratanordnung aus einem Chip und einem Chipträger zur Herstellung eines Chipmoduls;
**Fig. 3 bis 5** ein Verfahren zur Herstellung der in **Fig. 2** dargestellten Substratanordnung;
**Fig. 6 und 7** eine Variation des in den **Fig. 3 bis 5** dargestellten Verfahrens zur Herstellung der in **Fig. 2** dargestellten Substratanordnung.

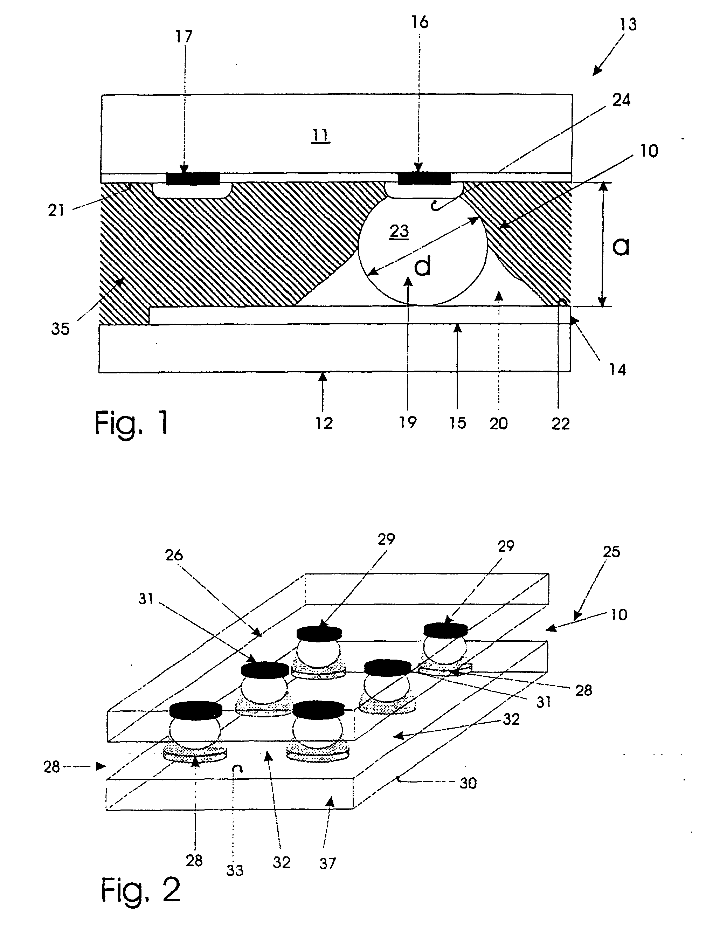

**Fig. 1** zeigt die Ausbildung einer Kontaktanordnung 10 bei einer aus einem Chip 11 und einem Spulensubstrat 12 gebildeten Substratanordnung zur Ausbildung eines Transponders 13. Derartige Transponder 13 werden zur kontaktlosen Datenübertragung genutzt und weisen als wesentliche Funktionselemente den Chip 11 sowie eine auf dem Spulensubstrat 12 ausgebildete Antennenspule 14 auf. Die Antennenspule 14 ist im vorliegenden Fall als Drahtspule ausgebildet mit Spulendrahtenden 15, die jeweils über eine Kontaktanordnung 10 mit einer zugeordneten Chipanschlußfläche 16 sowohl elektrisch leitend als auch mechanisch haltend verbunden sind. Ebenso können Anschlußenden geätzter oder gedruckter Spulen auf die vorstehende Art und Weise kontaktiert werden. Von mehreren Kontaktanordnungen 10 ist in **Fig. 1** lediglich eine dargestellt.

Neben den Chipanschlußflächen 16, die zur elektrischen Kontaktierung mit der Antennenspule 14 dienen, weist der Chip 11 weitere Testanschlüsse 17 auf, von denen in **Fig. 1** lediglich ein Testanschluß 17 dargestellt ist und die zur elektrischen Überprüfung des Chips 11 vor der Kontaktierung mit der Antennenspule 14 dienen und denen nach Kontaktierung des Chips 11 mit der Antennenspule 14 keine Funktion mehr zukommt.

Wie aus **Fig. 1** ersichtlich, ist die Kontaktanordnung 10 zwischen der Chipanschlußfläche 16 und dem Spulendrahtende 15 aus drei Komponenten aufgebaut, nämlich einer Zwischenmetallisierung 18, einer Abstandsmetallisierung 19 und einer leitfähigen Klebermasse 20. Im vorliegenden Fall wird für die unmittelbar auf die Aluminium-Anschlußfläche 16 des Chips 11 aufgebrachte Zwischenmetallisierung 18 eine Nickel und Gold enthaltende Legierung verwendet, die beispielsweise in einem stromlosen Metallabscheidungsverfahren auf die Chipanschlußfläche 16 haftend aufgebracht werden kann. Die Abstandsmetallisierung 19 ist demgegenüber aus einer konventionellen Lotlegierung, beispielsweise einer niedrigschmelzenden Blei/Zinn-Legierung, gebildet. Bei der in **Fig. 1** dargestellten Kontaktanordnung 10 erfolgt sowohl die elektrisch leitende Kontaktierung der Abstandsmetallisierung 19 mit dem Spulendrahtende 15 als auch die mechanische Verbindung zwischen der Abstandsmetallisierung 19 und dem Spulendrahtende 15 über die Klebermasse 20. Dabei wird die elektrische Verbindung über in der Klebermasse 20 enthaltene, elektrisch leitfähige Partikel und die mechanische Verbindung über die in der Klebermasse wirksamen Adhäsionskräfte realisiert.

Aus der Darstellung gemäß **Fig. 1** wird ferner deutlich, daß aufgrund der Kombination der Klebermasse 20 mit der Abstandsmetallisierung 19 eine mechanisch haltende, elektrisch leitfähige Verbindung zwischen der Abstandsmetallisierung 19 und dem Spulendrahtende 15 ohne Beeinflussung der im vorliegenden Fall als Kugel ausgebildeten Abstandsmetallisierung 19 ermöglicht wird. Hierdurch kann ein durch die Abstandsmetallisierung 19 ermöglichter Abstand a zwischen einer Kontaktoberfläche 21 des Chips 11 und einer im vorliegenden Fall durch die Oberfläche des Spulendrahtendes 15 gebildeten Kontaktoberfläche 22 des Spulensubstrats 12 im wesentlichen mit dem Durchmesser d der kugelförmig ausgebildeten Abstandsmetallisierung 19 gleichgesetzt werden. Von dieser vereinfachten Annahme kann im vorliegenden Fall ausgegangen werden, da die Zwischenmetallisierung 18, wie nachfolgend noch näher erläutert wird, lediglich zur Ausbildung einer mit zur Herstellung der Abstandsmetallisierung 19 verwendetem Lotmaterial 23 benetzbaren Oberfläche 24 dient.

**Fig. 2** zeigt eine als Chipmodul 25 ausgebildete Substratanordnung mit einem Chip 26 und einem Chipträger 27. Der Chipträger 27 ist mit einer hier nicht näher dargestellten Leiterbahnstruktur versehen, die ausgehend von Chipkontakten 28 des Chipträgers 27 auf einer Chipkontaktseite 33, die zur Kontaktierung mit Chipanschlüssen 29 des Chips 26 dienen, eine Umverteilung der Kontaktanordnung auf einer Außenkontaktseite 30 des Chipträgers 27 ermöglicht.

Der in **Fig. 2** dargestellte Chip 26 weist neben den Chipanschlüssen 29, die zur Kontaktierung mit dem Chipträger 27 dienen, noch zwei Testanschlüsse 31 auf, die zum Anschluß des Chips 26 an den Chipträger 27 nicht benötigt werden und lediglich zu einer der Kontaktierung vorausgehenden elektrischen Bauteilprüfung des Chips 26 dienen.

Wie aus **Fig. 2** ersichtlich, weist das Chipmodul 25 im vorliegenden Beispielsfall insgesamt sechs Kontaktanordnungen 10 auf, die, wie vorstehend bereits unter Bezugnahme auf **Fig. 1** beschrieben, aus drei Komponenten, nämlich der Zwischenmetallisierung 18, der Abstandsmetallisierung 19 und der Klebermasse 20, aufgebaut sind. Dabei dienen die sich zwischen den Chipanschlüssen 29 des Chips 26 und den Chipkontakten 28 des Chipträgers 27 erstreckenden Kontaktanordnungen 10 sowohl zur Herstellung einer elektrisch leitfähigen Verbindung als auch zur Herstellung einer das Chipmodul 25 mechanisch zusammenhaltenden Verbindung. Demgegenüber dienen die sich zwischen den Testanschlüssen 31 des Chips 26 und elektrisch inaktiven Oberflächenbereichen 32 der Chipkontaktfläche 33 des Chipträgers 27 erstreckenden Kontaktanordnungen 10 lediglich zur Herstellung einer das Chipmodul 25 zusammenhaltenden mechanischen Verbindung.

Wie in **Fig. 1** dargestellt, so ist es auch bei dem in **Fig. 2** dargestellten Chipmodul 25 möglich, einen zwischen der Chipoberfläche und der Chipkontaktseite des Chipträgers 27 ausgebildelen Zwischenraum 34 mit einem Füllmaterial 35 zu verfüllen.

Insbesondere dann, wenn zur Auffüllung des Zwischenraums 34 ein Füllmaterial 35 mit adhäsiven Eigenschaften verwendet wird, ist es möglich, die über die Klebermasse 20 der einzelnen Kontaktanordnungen 10 realisierte Adhäsionsverbindung lediglich temporär oder nur mit geringen Adhäsionskräften auszubilden, um anschließend durch das Füllmaterial 35 einen dauerhaft haltbaren Verbund zwischen dem Chip 26 und dem Chipträger 27 zu erzielen. Zur Verwendung als Füllmaterial 35 eignet sich besonders im vorgenannten Fall ein elektrisch isolierendes, thermisch aktivierbares Polymer.

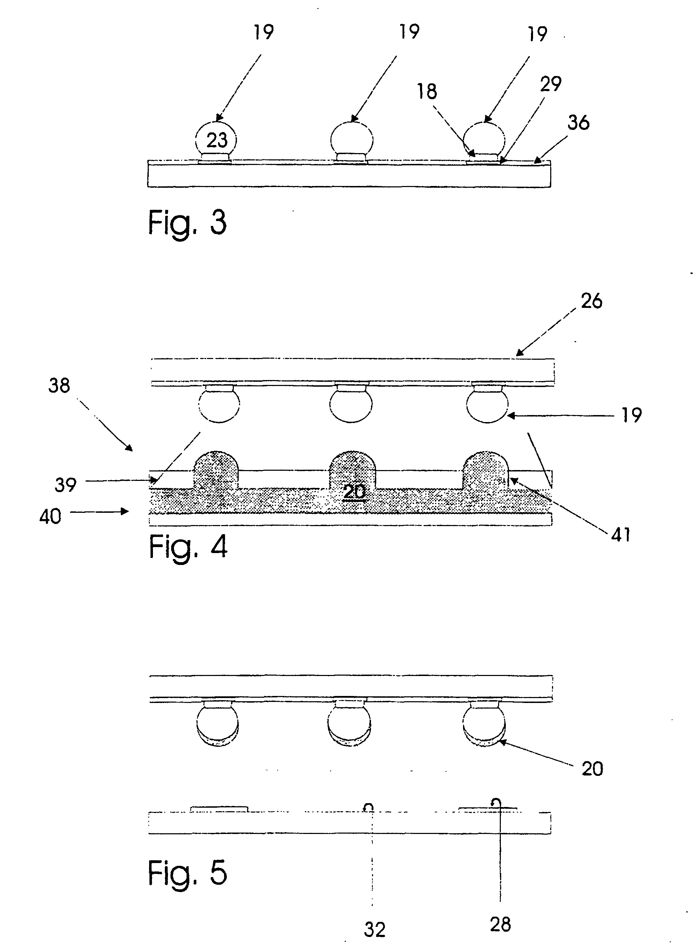

In den **Fig. 3** bis **5** ist nachfolgend die Vorgehensweise zur Herstellung der in **Fig. 2** dargestellten, hier beispielhaft als Chipmodul 25 ausgeführten Substratanordnung dargestellt.

**Fig. 3** zeigt den Chip 26 mit einer auf seiner aktiven Oberfläche angeordneten Passivierungsschicht 36, in der die Chipanschlüsse 29 angeordnet und bereits in einem vorhergehenden Verfahrensschritt mit der Zwischenmetallisierung 18 versehen sind. Zur Ausbildung der Abstandsmetallisierungen 19 befindet sich auch bereits auf den jeweiligen Zwischenmetallisierungen 18 ein durch Aufschmelzen zu einer Kugelform umgeschmolzenes Lotmaterial 23. Die Aufbringung des Lotmaterials 23 auf die Zwischenmetallisierungen 18 kann auf unterschiedliche Art und Weise erfolgen. So ist es beispielsweise möglich, das Lotmaterial 19 in einem Maskenverfahren als pastöses Material auf die Zwischenmetallisierungen 18 aufzubringen und anschließend zur Ausbildung der Abstandsmetallisierungen 19 in Kugelform aufzuschmelzen. Auch ist es möglich, das Lotmaterial 23 bereits zu Lotmaterialformstücken, beispielsweise Kugeln, ausgebildet auf die Zwischenmetallisierung 18 aufzubringen und nachfolgend durch Energiebeaufschlagung mit den Zwischenmetallisierungen 18 zumindest unter teilweisem Aufschmelzen zu verbinden. Darüber hinaus besteht auch die Möglichkeit, die kugelförmig ausgebildeten Abstandsmetallisierungen 19 unmittelbar, also ohne zwischenliegende Anordnung der Zwischenmetallisierung 18, auf die Chipanschlüsse 29 aufzubringen, vorausgesetzt, daß die gewählte Materialzusammensetzung eine ausreichende Benetzung der Chipanschlüsse 29 zur Ausbildung ausreichender Haltekräfte ermöglicht.

Wie in **Fig. 4** dargestellt, erfolgt nachfolgend die Applikation der Klebermasse 20 auf die Abstandsmetallisierungen 19. Im vorliegenden Fall wird zur Applikation der Klebermasse 20 auf die Abstandsmetallisierungen 19 eine Klebermassenausgabevorrichtung 38 verwendet, die in einer Abdeckeinrichtung 39 eines Aufnahmebehälters 40 Kapillarbohrungen 41 aufweist, die bei geeignetem Flüssigkeitsdruck der im Aufnahmebehälter 40 aufgenommenen Klebermasse 20 die Ausbildung von Flüssigkeitsmenisken 41 der Klebermasse 20 auf der Abdeckeinrichtung 39 ermöglichen. Zur Applikation von Klebermasse 20 auf die Abstandsmetallisierungen 19 wird, wie in **Fig. 4** dargestellt, der Chip 26 mit seinen Abstandsmetallisierungen 19 so auf die Abdeckeinrichtung 39 abgesenkt, daß die Abstandsmetallisierungen 19 durch die Flüssigkeitsmenisken 41 benetzt werden und bei einer Abnahme des Chips 26 von der Abdeckeinrichtung 39 eine entsprechende Menge der Klebermasse 20 an den Abstandsmetallisierungen 19 haften bleibt.

Wie **Fig. 5** zeigt, kann nunmehr der auf seinen Abstandsmetallisierungen 19 mit Klebermasse 20 versehene Chip 26 zur Kontaktierung mit dem hier als Chipträger 27 ausgebildeten weiteren Substrat in Flip-Chip-Technik so auf die Chipkontaktseite 33 des Chipträgers 27 abgesenkt werden, daß die auf den Abstandsmetallisierungen 19 angeordneten Klebermassen 20 mit den Chipkontakten 28 bzw. den elektrisch inaktiven Oberflächenbereichen 32 in Kontakt kommen. Hiermit ist die Konfiguration erreicht, in der entsprechend der Darstellung in **Fig. 2** die Kontaktanordnungen 10 ausgebildet sind.

In dieser Konfiguration kann dann durch geeignete Temperaturbeaufschlagung eine thermische Vorfixierung der Klebermassen 20 und nachfolgend, etwa nach Verfüllen des Zwischenraums 34 (**Fig. 2**) mit Füllmaterial 35, ein dauerhafter mechanischer Verbund zwischen dem Chip 26 und dem Chipträger 27 hergestellt werden.

Wie ferner aus einer Zusammenschau der **Fig. 2** und **5** besonders deutlich wird, ist es durch Verwendung der Klebermasse 20 zur Kontaktierung der Abstandsmetallisierungen 19 auf den Chipkontakten 28 bzw. den elektrisch inaktiven Oberflächenbereichen 32, die im vorliegenden Fall gegenüber den Chipkontakten 28 zurückversetzt sind, leicht möglich, Abstandsdifferenzen zwischen der Kontaktoberfläche 21 des Chips und der Chipkontaktseite 33 des Chipträgers 27 auszugleichen.

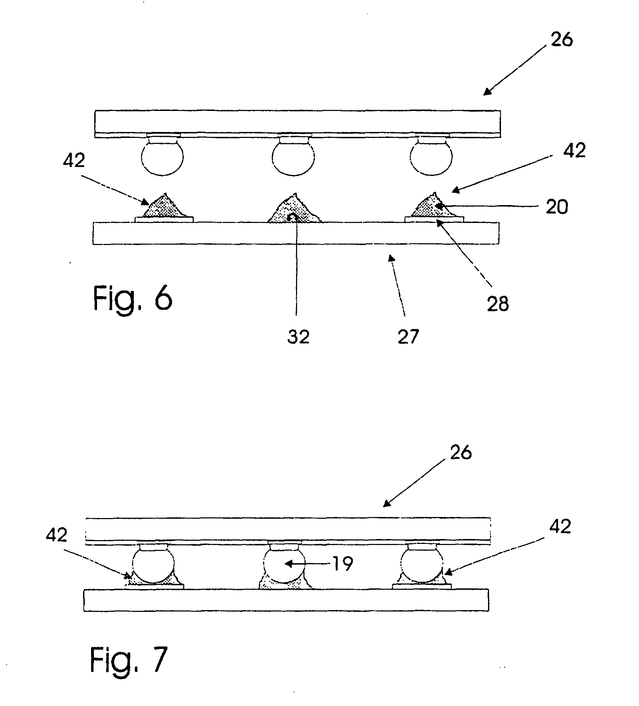

In den **Fig. 6 und 7** ist eine weitere Möglichkeit zur Applikation der Klebermasse 20 zwischen den Abstandsmetallisierungen 19 und den Chipkontakten 28 bzw. den elektrisch inaktiven Oberflächenbereichen 32 dargestellt. Hierbei ist in Vorbereitung der Kontaktierung des Chips 26 mit dem Chipträger 27 die Klebermasse 20 zur Ausbildung von Kleberdepots 42 mit einer hier nicht näher dargestellten Dosiereinrichtung auf die Chipkontakte 28 bzw. die elektrisch inaktiven Oberflächenbereiche 32 dosiert. Wie **Fig. 7** zeigt, erfolgt die Kontaktierung, indem der Chip 26 in Flip-Chip-Technik mit seinen Abstandsmetallisierungen 19 in die Kleberdepots 42 eingesetzt wird.

## Patentansprüche

1. Kontaktanordnung zur Verbindung zweier Substrate mit einem zumindest eine Anschlussfläche (16) aufweisenden ersten Substrat (11, 26), zumindest einer auf der Anschlussfläche des ersten Substrats angeordneten Abstandsmetallisierung (19) aus Lotmaterial und einem zweiten Substrat (12) mit einer Kontaktoberfläche (22), die mit der Anschlussfläche des ersten Substrats verbunden ist,
**dadurch gekennzeichnet,**
**dass** zwischen der Anschlussfläche (16) des ersten Substrats (11, 26) und der Abstandsmetallisierung (19) eine Zwischenmetallisierung (18) aus einer Nickel und Gold enthaltenden Legierung vorgesehen ist und daß das Lotmaterial diese Verbindung dadurch herstellt, daß es partiell aufgeschmolzen ist.

2. Verfahren zur Herstellung einer Kontaktanordnung zur Verbindung zweier Substrate mit den Verfahrensschritten:
- Aufbringung von Lotmaterial (23) auf Anschlussflächen (16) eines ersten Substrats (26) zur Ausbildung von Abstandsmetallisierungen (19), und
- Kontaktierung des ersten Substrats (26) mit einem zweiten Substrat (27), wobei die Kontaktierung zwischen den Anschlussflächen des ersten Substrats (26) und einer Kontaktoberfläche des zweiten Substrats (27) mittels eines partiellen Aufschmelzens der Abstandsmetallisierungen (19) erfolgt.

3. Verfahren nach Anspruch 2,
**dadurch gekennzeichnet,**
**dass** das partielle Aufschmelzen der Abstandmetallisierungen mittels einer Beaufschlagung der Abstandsmetallisierungen mit Laserenergie erfolgt.

## Claims

1. Contact structure for connecting two substrates comprising a first substrate (11, 26) having at least one terminal area (16), at least one spacing metallization (19) of soldering material disposed on the terminal area of the first substrate and a second substrate (12) having a contact surface (22) that is connected to the terminal area of the first substrate, **characterized in that** an intermediate metallization (18) composed of an alloy containing nickel and gold is provided between the terminal area (16) of the first substrate (11, 26) and the spacing metallization (19) and **in that** the solder material produces said connection **in that** it has been partially fused.

2. Process for producing a contact structure for connecting two substrates comprising the following process steps:
- application of solder material (23) to terminal areas (16) of a first substrate (26) to form spacing metallizations (19), and
- bonding of the first substrate (26) with a second substrate (27), the bonding between the terminal areas of the first substrate (26) and a contact surface area of the second substrate (27) being performed by means of a partial fusion of the spacing metallizations (19).

3. Process according to Claim 2, **characterized in that** the spacing metallizations are partially fused by means of application of laser energy to the spacing metallizations.

## Revendications

1. Dispositif de mise en contact pour assurer la liaison entre deux substrats, avec un premier substrat (11, 26), présentant au moins une surface de raccordement (16), au moins une métallisation d'espacement (19) en matériau de brasage, disposée sur la face de raccordement du premier substrat, et un deuxième substrat (12), avec une surface de contact (22) reliée à la surface de raccordement du premier substrat, **caractérisé en ce qu'**entre la surface de raccordement (16) du premier substrat (11, 26) et la métallisation d'espacement (19) est prévue une métallisation intermédiaire (18) en un alliage contenant du nickel et de l'or, et **en ce que**
cette liaison est produite par une mise en fusion partielle du matériau de brasage.

2. Procédé de fabrication d'un dispositif de mise en contact pour assurer la liaison de deux substrats, comportant les étapes consistant à :
- appliquer du matériau de brasage (23) sur des surfaces de raccordement (16) d'un premier substrat (26) pour réaliser des métallisations d'espacement (19), et
- mettre en contact le premier substrat (26) avec un deuxième substrat (27), la mise en contact entre les surfaces de raccordement du premier substrat (26) et une surface de contact du deuxième substrat (27) se faisant au moyen d'une fusion partielle des métallisations d'espacement (19).

3. Procédé selon la revendication 2, **caractérisé en ce que** la mise en fusion partielle des métallisations d'espacement s'effectue par exposition directe des métallisations d'espacement à de l'énergie venant d'un laser.
